# EUROPEAN PATENT SPECIFICATION

(11) **EP 1 692 768 B1**
(45) Date of publication and mention of the grant of the patent: **02.02.2011**
(21) Application number: 04814246.7
(22) Date of filing: 13.12.2004
(51) Int. Cl.: H03L 7/00

(54) **A PHASE LOCKED LOOP THAT SETS GAIN AUTOMATICALLY**
PHASENREGELKREIS, DER AUTOMATISCH VERSTÄRKUNG SETZT
BOUCLE A PHASE ASSERVIE REGLANT AUTOMATIQUEMENT LE GAIN

(30) Priority: 12.12.2003 GB 0328898
(43) Date of publication of application: 23.08.2006
(60) Divisional application: 08000503.6
(73) Proprietor: Qualcomm, Incorporated, San Diego, CA 92121 (US)
(72) Inventor: SMITH, Alan, Andrew (deceased), (GB); HARRIS, Mark V., Farnborough GU14 7LS (GB)
(74) Representative: Wagner, Karl H.
(86) International application number: PCT/US2004/042040
(87) International publication number: WO 2005/060103

(56) References cited:
- EP-A- 0 500 014
- EP-A- 0 500 014
- EP-A- 0 732 830
- WO-A-96/29785
- WO-A-96/29785
- WO-A-03/052936
- WO-A-03/052936
- WO-A-2004/004126
- WO-A-2004/004126
- JP-A- 1 241 920
- JP-A- 61 245 628
- US-A- 3 783 394
- US-A- 3 783 394
- US-A- 4 394 778
- US-A- 4 394 778
- US-A- 4 562 410
- US-A- 4 562 410
- US-A- 5 382 922
- US-A- 5 382 922
- US-A- 5 678 200
- US-A- 5 678 200
- US-A- 5 973 572
- US-A- 5 973 572
- US-A1- 2002 159 351
- US-A1- 2002 159 351
- US-B1- 6 188 289
- US-B1- 6 188 289
- US-B1- 6 249 189
- US-B1- 6 329 847
- US-B1- 6 329 847
- US-B1- 6 496 556
- PATENT ABSTRACTS OF JAPAN vol. 006, no. 151 (E-124), 11 August 1982 (1982-08-11) & JP 57 072430 A (MITSUBISHI ELECTRIC CORP), 6 May 1982 (1982-05-06)
- PATENT ABSTRACTS OF JAPAN vol. 017, no. 009 (E-1303), 8 January 1993 (1993-01-08) & JP 04 240921 A (YOKOGAWA ELECTRIC CORP), 28 August 1992 (1992-08-28)
- PATENT ABSTRACTS OF JAPAN vol. 009, no. 284 (E-357), 12 November 1985 (1985-11-12) & JP 60 125021 A (MATSUSHITA DENKI SANGYO KK), 4 July 1985 (1985-07-04)
- PATENT ABSTRACTS OF JAPAN vol. 006, no. 243 (E-145), 2 December 1982 (1982-12-02) & JP 57 141137 A (FUJITSU KK), 1 September 1982 (1982-09-01)
- YEAGER R: "LOOP GAIN COMPENSATION IN PHASE-LOCKED LOOPS" RCA REVIEW, RCA CORP. PRINCETON, US, vol. 47, 1 March 1986 (1986-03-01), pages 78-87, XP002011878
- PATENT ABSTRACTS OF JAPAN vol. 006, no. 151 (E-124), 11 August 1982 (1982-08-11) & JP 57 072430 A (MITSUBISHI ELECTRIC CORP), 6 May 1982 (1982-05-06)
- PATENT ABSTRACTS OF JAPAN vol. 017, no. 009 (E-1303), 8 January 1993 (1993-01-08) & JP 04 240921 A (YOKOGAWA ELECTRIC CORP), 28 August 1992 (1992-08-28)
- PATENT ABSTRACTS OF JAPAN vol. 009, no. 284 (E-357), 12 November 1985 (1985-11-12) & JP 60 125021 A (MATSUSHITA DENKI SANGYO KK), 4 July 1985 (1985-07-04)
- PATENT ABSTRACTS OF JAPAN vol. 006, no. 243 (E-145), 2 December 1982 (1982-12-02) & JP 57 141137 A (FUJITSU KK), 1 September 1982 (1982-09-01)

## Description

### BACKGROUND

The invention relates to a phase-locked loop. More specifically, the invention relates to a phase-locked loop that sets gain automatically.

Mobile telephones and other communication transceivers generally comprise separate transmit and receive circuits that share a single frequency-synthesizer. The frequency-synthesizer serves as a local oscillator for both the transmit and receive circuits of the transceiver. These frequency-synthesizers typically comprise a phase-locked loop (PLL) that can be controlled to oscillate at specific frequencies. When the telephone is receiving signals the PLL will be controlled to oscillate at a receiving frequency and when the telephone is transmitting the PLL will be controlled to oscillate at a transmitting frequency.

Many modem mobile telephones are designed to operate in plural different cellular systems owned by different operators and operated under different communications standards. This usually means that the telephone's receiver must be able to receive signals at widely different frequencies and to switch quickly between those frequencies. The same is also true of the transmitter.

When the receiver (or transmitter) changes from one frequency to another, there is a period of time when the local oscillator is not locked onto a frequency. No communication is possible during this period of time and the mobile phone has to wait for the local oscillator to lock onto a frequency before over the air communications can resume.

If the local oscillator remains unlocked on a frequency for too long operation of the telephone could be interrupted. At the very least this will result in degradation in the user's perception of the quality of service. At worst it could result in a termination of the communication. It is therefore desirable to minimize the time the oscillator remains unlocked. One way of minimizing that time is to decrease the time taken for the PLL to change between different frequencies.

The overall gain of a PLL is a factor that affects the rate at which the PLL can change from one operating frequency to another. A PLL with a high gain will change more quickly between frequencies than a PLL with a lower gain. A PLL with lower gain is more stable once locked onto the desired frequency. However, when using a lower gain PLL for large frequency changes a condition known as cycle skip can occur. Cycle skip occurs when the phase error increases and exceeds 360 degrees. At the point where the phase error exceeds 360 degrees there is a sharp transition. When a PLL encounters this sharp transition it greatly lengthens the time it takes for a PLL to return to less than 360 degrees of error and lock onto a new frequency. A higher gain PLL generally will tolerate larger frequency changes without cycle skip occurring.

To take advantage of the benefits of both high and low gain in a PLL, current systems tend to utilise PLLs with selectable gains. Commercially available PLLs generally offer a choice of gain values programmable for the phase detector. By adjusting the gain of the phase detector the overall gain of the PLL can be adjusted. A low gain is selected when the PLL is locked onto a frequency and a high gain is selected during changes from one frequency to another.

Current techniques that use different phase detector gains involve programming the phase detector for each gain change. For example, a PLL is programmed to an initial or first frequency. While locked onto this first frequency the phase detector is at low gain. When a change in frequency is initiated, the PLL is programmed to a second frequency; and, the phase detector is simultaneously programmed to high gain. As the PLL approaches the second frequency, the phase detector is then re-programmed to low gain. Alternately, the phase detector could be re-programmed to reduce gain based on time at high gain rather than proximity to the second frequency.

Repeated re-programming of the PLLs consumes valuable processor time in current techniques.

Further attention is drawn to document US 6,188,289, which discloses a wide range voltage controlled oscillator including a voltage-to-current conversion unit generating a control current responsive to a control voltage, and an offset current generation unit generating an offset current. The offset current generation unit is responsive to the control voltage and, at certain times, is responsive to a reference voltage. An adding unit adds the control current to the offset current, and generates an oscillation control current. An oscillation unit generates the oscillation signal responsive to the oscillation control current.

Attention is also drawn to the document YEAGER R: "LOOP GAIN COMPENSATION IN PHASE-LOCKED LOOPS" RCA REVIEW, RCA CORP. PRINCETON, US, vol. 47, 1 March 1986 (1986-03-01), pages 78-87, XP002011878. The document discusses a method for adjustment of phase detector gain to compensate for variations in division factors and in voltage controlled oscillators, leading in turn to differences in closed-loop frequency response of phase locked loops.

Furthermore attention is drawn to document EP-A-0 500 014, which discusses a phase difference signal generator responding to two input signals to generate two phase difference signals which rise at a time interval corresponding to the phase difference between the two input signals and fall at the same time. A lagging signal detector detects a lagging one of the two phase difference signals and a pulse generator responds to the detected output from the lagging signal detector to generate an appendage pulse of a width larger than a predetermined width. The appendage pulse is appended, by a pulse appending circuit, to each of the two phase difference signals to form an extended phase difference signal. A phase difference detector detects the difference between the two extended phase difference signals and outputs a low-frequency component of the difference as a voltage corresponding to the phase difference between the two input signals.

Attention is drawn to the document JP-57141137, which sets out to shorten a leading-in time by detecting a shift in output frequency from a center frequency and by switching loop grains on the basis of the detected value. The document teaches that the phase of an input signal is compared with that of an output signal by a phase comparator, and on the basis of its phase difference output, a voltage-controlled oscillator is controlled to obtain an output signal whose phase synchronizes with that of the input signal. Then, a frequency variation detector detects the output signal shifting in frequency from a center frequency by a threshold frequency or more, and on the basis of its detection output, a loop gain switch is controlled to switch a loop gain G2 to a G1, thereby shortening a leading-in time during power feeding and after recovery from a break of the input signal. When the output frequency decreases below the threshold frequency, the loop gain is reset to the original one, thus performing stabilization.

Finally attention is drawn to document US 6356158, wich discloses a P22 having a phase detector wich is responsive to a gain control signal. The document teaches that the time to lock is improved by using a higher gain of the phase detector for an initial period of the lock step and when switching to lower gain for the remainder of the lock step. The gain is set after a predetermined time duration.

In accordance with the present invention, a method for automatically setting gain in a phase locked loop, as set forth in claim 1, is provided. Embodiments of the invention are claimed in the dependent claims.

According to one aspect of the invention there is provided a phase locked loop PLL, that sets gain automatically. The PLL comprising a frequency discriminator for providing a first signal that represents the difference between a first frequency and a second frequency. The PLL also comprising a comparator coupled to the frequency discriminator for receiving the first signal and providing a second signal based on information from the first signal. The second signal is representative of a gain setting for the phase locked loop to set.

According to another aspect of the invention there is provided a method for automatically setting gain in a phase locked loop, PLL, in which the PLL comprises a phase detector. The method comprising initiating a frequency change in the operation of the PLL from a first frequency to a second frequency, increasing gain of the phase detector at the beginning of the frequency change, and decreasing gain of the phase detector based on a predetermined characteristic of the operation of the PLL during the frequency change.

The above and further features of the invention are set forth with particularity in the appended claims and together with advantages thereof will become clearer from consideration of the following detailed description of an exemplary embodiment of the invention given with reference to the accompanying drawings.

### BRIEF DESCRIPTION OF THE DRAWINGS

In the drawings:
Figure 1 is a block diagram of a phase locked loop that sets gain independently;
Figure 2 is a graphical representation of the functional relationship between input signal A and output signal B for a window comparator;
Figure 3 is an implementation of a frequency discriminator of the phase locked loop of figure 1;
Figure 4 is an alternate implementation of a frequency discriminator and a window comparator;
Figure 5 is a block diagram of an implementation of a look up table which contains time value information used to determine the duration of high gain for a PLL during a frequency change.

### DETAILED DESCRIPTION

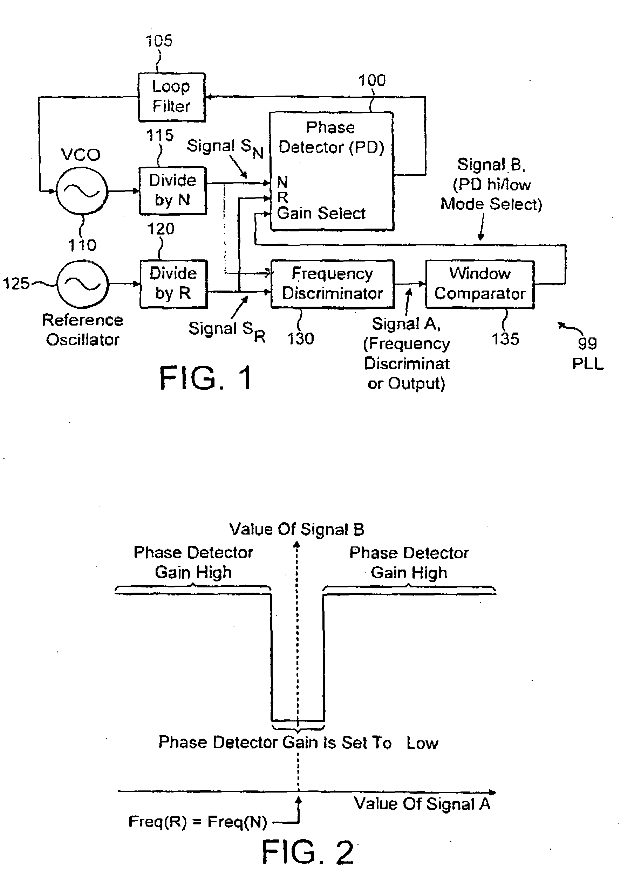

Turning now to Figure 1 of the accompanying drawings there is shown a phase-locked loop (herein after referred to as a PLL) 99, in which high gain and low gain are set automatically. That is to say the gains of the PLL are set without intervention by an external controller such as a mobile phone system processor. For simplicity of description, two gain settings are discussed, low gain and high gain. It will be appreciated by those possessed of the appropriate skills that multiple gain settings can be used.

A voltage controlled oscillator (herein after referred to as a VCO) 110 drives a programmable divide-by-N counter 115, to provide a signal SN at the output of the counter 115. Reference oscillator 125 drives a programmable divide-by-R counter 120, to provide signal SR at the output of counter 120. A frequency discriminator 130, receives and uses signal SN and signal SR to provide a signal A to window comparator 135. The signal A is representative of the difference between the two input signals, signal SN and signal SR. The window comparator 135 receives the signal A and applies a function thereto, which causes signal B to be generated and provided to a to a phase detector 100. The phase detector 100 receives the signal SN and the signal SR, and provides feedback through a loop filter 105 to the VCO 110. The phase detector 100 also receives signal B and uses signal B to determine the appropriate phase detector gain settings.

In Figure 2 or the accompanying drawings there is shown a graphical representation of the function of signal B in relation to signal A. In this example, when the difference between signal SN and signal SR (represented by signal A) is close to zero, signal B is low. When the difference (represented by signal A) is above a preset level (positive or negative), signal B is high. Phase detector 100 uses the high or low signal to set gains high or low respectively. In this way, the phase detector 100 gain stays set low for small frequency changes and is only switched to high for larger frequency changes.

It will be appreciated by those possessed of the appropriate skills that the transition between low and high gain does not have to be a square function as depicted in Figure 2. Smoother transitions using multiple different gains can be used as design requirements dictate.

Loop gain is set by adjusting the gain of the phase detector 100. It will also be appreciated that loop gain can be adjusted in other ways. For example, adjusting the gain of VCO 110 or loop filter 105 could also be used to adjust the overall phase locked loop gain.

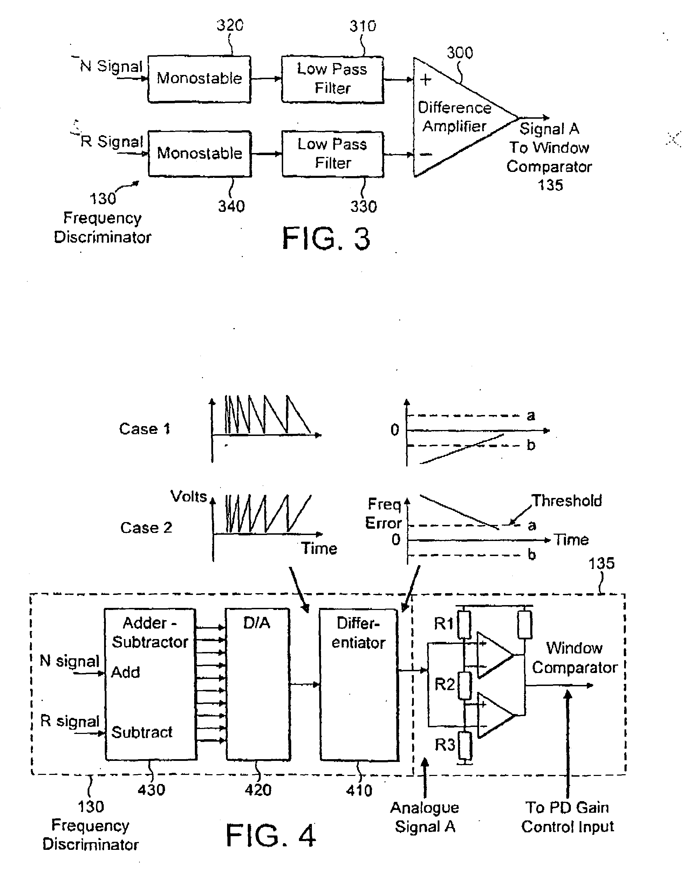

Turning now to Figure 3 there is shown in more detail an implementation of the frequency discriminator 130. A first monostable 320 has an input coupled to receive signal SN from the counter 115 and an output coupled to a first low pass filter 310. A second monostable 340 has an input coupled to receive signal SR from the counter 120 and an output coupled to a second low pass filter 330. The first and second low pass filters 310 and 330 have outputs coupled to a difference amplifier 300 which in turn has an output coupled to provide a signal to the window comparator 135 (see Figure 1).

Each combination of monostable (320, 340) and low pass filter (310, 330) provides a signal with a DC level that is linearly proportional to the frequency of the signal at the monostable input. The difference amplifier 300 receives the signals from the low pass filters (320, 330), compares the two signals and provides to the window comparator 135 a signal A that is proportional to the difference in the frequencies of the signals SN and SR.

An alternative implementation of frequency discriminator 130 and window comparator 135 is shown in more detail in Figure 4. A digital adder-subtractor 430 receives signal SN and signal SR. The output of the adder-subtractor 430 operates so that each pulse from signal SN increments the output by one and each pulse from signal SR decrements the output by one. Thus, when the frequencies of signal SN and SR are equal (or the frequency difference is zero) the output of the adder-subtractor stabilizes at a value. In practice, a reset feature could be used to force the stabilized value to be equal to zero.

The output from the adder-subtractor 430 is provided to a digital to analog converter DAC 420. The output of the DAC 420 is provided to a differentiator 410 through a low-pass filter (not shown), with which differentiator 410 provides an output to the window comparator 135. The differentiator 410 output is linearly proportional to the frequency difference between signal SN and signal SR.

Looking more closely at the output of the differentiator 410 as is provided to the window comparator 135, the operation of the window comparator 135 depends on the voltage of the signal from the differentiator 410. If the signal from the differentiator 410 is above a preset threshold in relation to zero or below a preset threshold in relation to zero then the output of the window comparator 135 is high. If the signal from the differentiator 410 is smaller than a preset value then the output of the window comparator 135 is low. The output of the window comparator 135 is received by the phase detector 100 and causes the gain of the phase detector 100 to be set to a high or a low value depending on whether the window comparator signal is high or low respectively. In the circuit shown in Figure 4 the thresholds are determined by the values of resistors R1, R2 and R3.

Further shown in Figure 4 are case 1 and case 2, which are graphical representations of the relationship between signal A output by the differentiator 410 and the input to the differentiator 410. In case 1 and 2, when the saw tooth gradient is decreasing with time the difference in frequency is reducing. In the region above (a) or below (b) the window comparator 135 sets signal B to high. In the region bracketed by (a) and (b) around the zero frequency error line, the window comparator 135 sets signal B to low. The phase detector 100 reacts by setting phase detector gain to low or high based on signal B respectively being low or high.

An alternative implementation for selecting low gain at the near completion of a frequency change is to select low gain once the frequency error changes sign. This would occur when the frequency error (difference between the desired frequency and the present frequency, represented by case 1 or case 2) value crosses the frequency error equals zero line. Until the zero error line is crossed the PLL would maintain high gain.

Another alternative implementation is for low gain to be selected based on the rate of change of the frequency error. As the desired frequency is approached, the rate of change at which phase detector 100 is changing will be reducing in relation to the proximity to the desired frequency. Once a predetermined rate of change is reached low gain is signalled to the phase detector. The phase detector responds by selecting low gain.

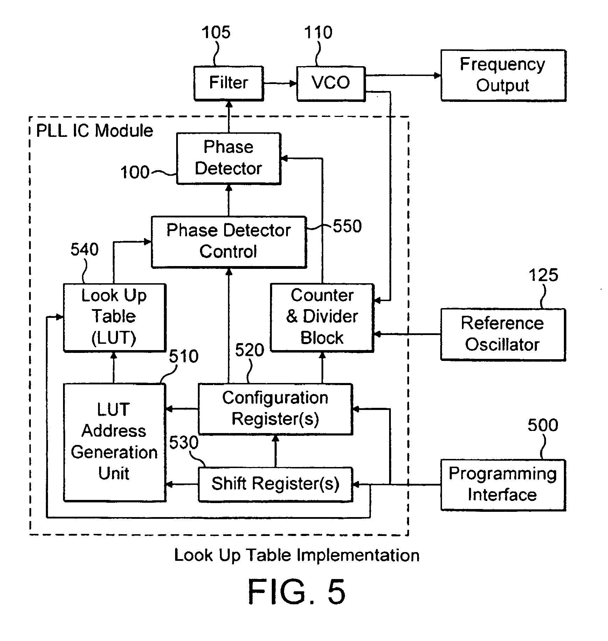

Turning to Figure 5 there is shown a block diagram of a PLL in which a look up table (LUT) 540 is used to determine the duration of the high gain setting for the PLL to use during a frequency change. The values stored in the LUT are the time values for which the PLL maintains high gain. Once high gain is set for a frequency change the PLL will return to low gain automatically based on time at high gain.

The programming interface 500 initialises the LUT 540. If the LUT is read only memory (ROM) based then this operation is not applicable. The programming interface 500 is also used to program the registers 520 and 530.

The LUT address generation unit 510 compares the current active configuration of the PLL stored in the configuration register(s) 520, to the new configuration stored in the shift register(s) 530 and outputs an address to the LUT 540. At this address in the LUT 540 is a time value which represents the length of time over which the PLL applies high gain during a frequency change. The time value from the LUT 540 is provided to the phase detector control 550.

The phase detector control 550 provides the PLL with the time value over which the PLL applies high gain during a frequency change along with an indication that high gain be selected for the phase detector 100.

In this way the system processor is used to initially program the PLL to high gain for a frequency change but the processor is not used for the follow-on reduction in gain when the PLL nears the desired frequency. Once the appropriate time has gone by, the PLL returns to low gain automatically.

Look up tables (LUTs) tend to be expensive in terms of chip space and it is therefore desirable to use small LUTs where possible. However, system requirements often dictate the use of a large LUT.

For example, in wireless communication, primary Global System for Communication, GSM, has 124 discrete radio frequency channels. A LUT that provides a direct mapping from any channel to any other channel would be a 124 X 124 element matrix. Memory requirements and hardware requirements to hold the data for a LUT matrix of this size is large.

In order to reduce the size of the LUT for the PLL of Figure 5, entries are grouped together and averaged to produce a single entry that will serve multiple channel changes.

In GSM the LUT size is reduced to a 31 X 31 element matrix by grouping sets of 4 elements together and averaging them. Significantly less memory is required to store the elements of the reduced matrix due to the significantly fewer number of elements. Each entry represents the time duration at high gain for the PLL to maintain for a frequency change. Each high gain duration value applies to four GSM channels. The averaging of the matrix elements sacrifices some degree of accuracy and performance but is more manageable from a memory size stand point.

In operation, starting channel (Cs) which is one of the 124 available GSM channels, is divided by 4 to identify its starting channel group (Gs). The starting channel group is representative of one of the elements of the reduced 31X31 element matrix. The destination channel (Cd) is also divided by 4 to identify it's destination channel group (Gd). In this way the PLL uses the high gain duration stored in LUT element (Gs,Gd) when changing from starting channel Cs to destination channel Cd.

In expressive form:
Gs=Cs divided by 4
Gd=Cd divided by 4
High Gain Duration= LUT (Gs,Gd)

A more specific example of the implementation is the PLL has a requirement to transition from channel 120 to channel 45. The starting channel group: Gs = 120/4 = 30. Thus starting channel, Cs=120, is a member of starting channel group 30 of the reduced matrix. The destination channel group: Gd = 45/4 = 11.25. In this situation all fractions are rounded up to the nearest whole number and thus the destination channel, Cd=45 is a member of the destination channel group 12.

Further reductions in the size of the LUT are achieved when the high gain duration required to go from Cs to Cd is the same as when going from Cd to Cs. In operation, only one set of values is used. The elements of the matrix that are duplicates are not required to be stored in memory.

Additional hardware size reductions might suggest that the LUT be read only memory (ROM) based. This requires less hardware than a comparative random access memory (RAM). Significant circuit changes however impose the added requirement of refabricating the ROM contents each time there is a change.

To maximize a LUT performance, the circuit that is associated with the LUT should be fully characterized. For a circuit to be fully characterized, the circuit is built and evaluated as to the circuit's actual operating characteristics. The operating characteristics are specific to the hardware and the construction methods used to build the circuit. The circuit's actual operating characteristics are used to develop accurate information for the elements of the LUT. Significant circuit alterations would however necessitate reevaluation of the information for the LUT elements.

It will be appreciated by those possessed of appropriate skill that the approach of using a LUT to set PLL gains would be well suited for applications where reducing processor involvement with PLL gain settings is of high priority in relation to memory or hardware size requirements.

## Claims

1. A method for automatically setting gain in a phase locked loop, PLL, (99) in which the PLL (99) comprises a phase detector (100), the method comprising:
initiating a frequency change in the operation of the PLL (99) from a first frequency to a second frequency;
increasing gain of the phase detector (100) at the beginning of the frequency change; and
decreasing gain of the phase detector (100);
determining a difference between the first frequency and the second frequency,
**characterized in that** the method further comprises:
wherein determining a difference between the first frequency and the second frequency comprises:
receiving at an adder-subtractor (430) the first frequency signal and the second frequency signal and providing a digital signal;
converting at a digital to analog converter (420) the digital signal to an analog signal; and
receiving at a differentiator (410) the analog signal and generating a first signal (A), wherein the first signal (A) is representative of the difference between the first frequency signal and the second frequency signal
receiving, at a window comparator (135), from the differentiator (410) the first signal (A);
comparing the first signal (A) to thresholds relating to the frequency difference, wherein the thresholds define a predetermined comparison window;
generating a second signal (B) based on the comparison and providing the second signal (B) to a phase detector (100);
receiving at the phase detector (100) the second signal (B), the phase detector (100) being operable at multiple gains as a function of the second signal (B); and wherein decreasing the gain of the phase detector (100) is based on said second signal (B).

2. The method of claim 1, wherein the phase detector (100) is operable at two gains.

3. The method of claim 1 wherein said thresholds comprise a first threshold value (a) corresponding to a first value of the frequency difference and a second threshold value (b) corresponding to a second value of the frequency difference.

4. The method of any of claim 3 wherein the gain of the phase detector (100) is set to a higher gain value for values of the first signal (A) which are outside the predetermined comparison window and the gain of the phase detector (100) is 15 set to a lower gain value for values of the first signal (A) which are within the predetermined comparison window.

5. The method of claim 1, wherein the gain is reduced when the frequency difference is zero.

## Patentansprüche

1. Ein Verfahren zum automatischen Einstellen der Verstärkung in einer Phasenverriegelungsschleife, PLL, (99) in dem die PLL (99) einen Phasendetektor (100) aufweist, wobei das Verfahren Folgendes aufweist:
Initiieren einer Frequenzänderung in der Operation der PLL (99) von einer ersten Frequenz zu einer zweiten Frequenz;
Erhöhen der Verstärkung des Phasendetektors (100) beim Beginn der Frequenzänderung; und
Vermindern der Verstärkung des Phasendetektors (100);
Bestimmen einer Differenz zwischen der ersten Frequenz und der zweiten Frequenz, **gekennzeichnet dadurch, dass** das Verfahren weiterhin Folgendes aufweist:
wobei Bestimmen einer Differenz zwischen der ersten Frequenz und der zweiten Frequenz Folgendes aufweist:
Empfangen bei einem Addierer-Subtrahierer (430) des ersten Frequenzsignals und des zweiten Frequenzsignals und Vorsehen eines digitalen Signals;
Konvertieren bei einem Digital-zu-Analog-Konverter (420) des digitalen Signals in ein analoges Signal; und
Empfangen bei einem Differenzierungselement (410) des analogen Signals und Generieren eines ersten Signals (A), wobei das erste Signal (A) repräsentativ ist für die Differenz des ersten Frequenzsignals und des zweiten Frequenzsignals;
Empfangen bei einem Fenstervergleicher (135) von dem Differenzierungselement (410) des ersten Signals (A);
Vergleichen des ersten Signals (A) mit Schwellen, die sich auf die Frequenzdifferenz beziehen, wobei die Schwellen ein vordefiniertes Vergleichsfenster definieren;
Generieren eines zweiten Signals (B), basierend auf dem Vergleich und Vorsehen des zweiten Signals (B) an einen Phasendetektor (100);
Empfangen bei dem Phasendetektor (100) des zweiten Signals (B), wobei der Phasendetektor (100) mit mehreren Verstärkungen als eine Funktion des zweiten Signals (B) betreibbar ist; und
wobei das Vermindern der Verstärkung des Phasendetektors (100) auf dem zweiten Signal (B) basiert.

2. Verfahren nach Anspruch 1, wobei der Phasendetektor (100) mit zwei Verstärkungen betreibbar ist.

3. Verfahren nach Anspruch 1, wobei die Schwellen einen ersten Schwellenwert (a) entsprechend einem ersten Wert der Frequenzdifferenz und einen zweiten Schwellenwert (b) aufweisen, entsprechend einem zweiten Wert der Frequenzdifferenz.

4. Verfahren nach Anspruch 3, wobei die Verstärkung des Phasendetektors (100) auf einen höheren Verstärkungswert für Werte des ersten Signals (A) gesetzt wird, die sich außerhalb des vordefinierten Vergleichsfensters befinden und die Verstärkung des Phasendetektors (100) auf einen niedrigeren Verstärkungswert für Werte des ersten Signals (A) gesetzt wird, die sich innerhalb des vorbestimmten Vergleichsfensters befinden.

5. Verfahren nach Anspruch 1, wobei die Verstärkung reduziert wird, wenn die Frequenzdifferenz Null ist.

## Revendications

1. Procédé pour régler automatiquement un gain dans une boucle à verrouillage de phase, PLL, (99), dans laquelle la PLL (99) comprend un détecteur de phase (100), le procédé comprenant :
lancer un changement de fréquence dans le fonctionnement de la PLL (99) d'une première fréquence vers une deuxième fréquence ;
augmenter le gain du détecteur de phase (100) au début du changement de fréquence ; et
diminuer le gain du détecteur de phase (100) ;
déterminer une différence entre la première fréquence et la deuxième fréquence,
**caractérisé en ce que** le procédé comprend en outre le fait que :
la détermination d'une différence entre la première fréquence et la deuxième fréquence comprend les étapes suivantes:
recevoir au niveau d'un additionneur-soustracteur (430) le premier signal de fréquence et le deuxième signal de fréquence et fournir un signal numérique ;
convertir au niveau d'un convertisseur numérique-analogique (420) le signal numérique en un signal analogique ; et
recevoir au niveau d'un différenciateur (410) le signal analogique et générer un premier signal (A), le premier signal (A) étant représentatif de la différence entre le premier signal de fréquence et le deuxième signal de fréquence ;
recevoir, au niveau d'un comparateur à fenêtre (135), en provenance du différenciateur (410), le premier signal (A) ;
comparer le premier signal (A) à des seuils associés à la différence de fréquence, les seuils définissant une fenêtre de comparaison prédéterminée ;
générer un deuxième signal (B) sur la base de la comparaison et fournir le deuxième signal (B) à un détecteur de phase (100) ;
recevoir au niveau du détecteur de phase (100) le deuxième signal (B), le détecteur de phase (100) étant actionnable à plusieurs gains en fonction du deuxième signal (B) ;
et la diminution du gain du détecteur de phase (100) étant basée sur le deuxième signal (B).

2. Procédé selon la revendication 1, dans lequel le détecteur de phase (100) est actionnable à deux gains.

3. Procédé selon la revendication 1, dans lequel les seuils comprennent une première valeur de seuil (a) correspondant à une première valeur de la différence de fréquence et une deuxième valeur de seuil (b) correspondant à une deuxième valeur de la différence de fréquence.

4. Procédé selon la revendication 3, dans lequel le gain du détecteur de phase (100) est mis à une valeur de gain supérieure pour des valeurs du premier signal (A) qui sont en dehors de la fenêtre de comparaison prédéterminée et le gain du détecteur de phase (100) est mis à une valeur de gain inférieure pour des valeurs du premier signal (A) qui sont dans la fenêtre de comparaison prédéterminée.

5. Procédé selon la revendication 1, dans lequel le gain est réduit lorsque la différence de fréquence est nulle.
